# EUROPÄISCHE PATENTSCHRIFT

(11) **EP 2 691 997 B1**
(45) Veröffentlichungstag und Bekanntmachung des Hinweises auf die Patenterteilung: **13.09.2017**
(21) Anmeldenummer: 12712977.3
(22) Anmeldetag: 07.03.2012
(51) Int. Cl.: H01L 51/54, C07F 1/02

(54) **KOMPLEXIERUNG NIEDERMOLEKULARER HALBLEITER FÜR DIE ANWENDUNG ALS EMITTERKOMPLEX IN ORGANISCHEN LICHTEMITTIERENDEN ELEKTROCHEMISCHEN ZELLEN (OLEECS)**
COMPLEXATION OF LOW-MOLECULAR SEMICONDUCTORS FOR THE APPLICATION AS AN EMITTER COMPLEX IN ORGANIC LIGHT-EMITTING ELECTROCHEMICAL CELLS (OLEECS)
COMPLEXATION DE SEMI-CONDUCTEURS À BAS POIDS MOLÉCULAIRE POUR UNE UTILISATION COMME COMPLEXE ÉMETTEUR DANS DES CELLULES ÉLECTROCHIMIQUES PHOTOÉMETTRICES ORGANIQUES (OLEECS)

(30) Priorität: 29.03.2011 DE 102011006360
(43) Veröffentlichungstag der Anmeldung: 05.02.2014
(73) Patentinhaber: OSRAM OLED GmbH, 93049 Regensburg (DE)
(72) Erfinder: KRESTEL, Ana-Maria, 91052 Erlangen (DE); SCHMID, Günter, 91334 Hemhofen (DE); TAROATA, Dan, 91054 Erlangen (DE); HARTMANN, David, 91056 Erlangen (DE); SARFERT, Wiebke, 91074 Herzogenaurach (DE)
(74) Vertreter: Epping - Hermann - Fischer
(86) Internationale Anmeldenummer: PCT/EP2012/053892
(87) Internationale Veröffentlichungsnummer: WO 2012/130571

(56) Entgegenhaltungen:
- WO-A2-03/103067
- CHRISTIANE DIETRICH-BUCHECKER ET AL.: "Synthesis of Multi-1,10-phenanthroline Ligands with 1,3-Phenylene Linkers and Their Lithium Complexes", CHEMISTRY - A EUROPEAN JOURNAL, Bd. 11, 18. Juli 2005 (2005-07-18), XP002675595,
- A. S. DENISOVA AND M. B. LYSINOVA: "IR Study of Complexation in the System 1,10-Phenanthroline-LiClO4 (NaClO4)-Acetone", RUSSIAN JOURNAL OF GENERAL CHEMISTRY, Bd. 72, Nr. 6, 30. Juni 2002 (2002-06-30), Seiten 823-833, XP002675596,

## Beschreibung

Die vorliegende Erfindung betrifft organische Halbleiterbauelemente, insbesondere OLEECs, und deren Herstellung.

Im Bereich der organischen Halbleiter sind bislang vor allem organische lichtemittierende Dioden (OLEDs) als lichtemittierende Bauelemente bekannt. Dabei werden OLEDs aus niedermolekularen Verbindungen und OLEDs aus Polymeren unterschieden. Während die OLEDs aus niedermolekularen Verbindungen, besser bekannt unter dem englischen Begriff small molecules, mit Hilfe von Multilagensystemen sehr effiziente Bauteile ergeben, besteht der Vorteil der polymeren OLEDs in den einfacheren und kostengünstigeren Herstellungsprozessen.

Die Druckschrift D1 (WO 03/103067 A2) beschreibt ein elektrolumineszierendes Bauelement, welches einen elektrolumineszierenden Metall-Ion-Komplex und ein elektrolumineszierendes Polymer aufweist.

Der neue Bauteiltyp der lichtemittierenden elektrochemischen Zellen weist ebenso wie die Polymer-OLED die kostengünstige Fertigungsweise auf. Eine OLEEC weist im einfachsten Fall nur eine einzige aktive Schicht auf, die verschiedene ionische Verbindungen aufweist. Erst im Betrieb des Bauteils, d.h. erst nach Anlegen einer Bauteilspannung, werden die negativ geladenen Teile der ionischen Verbindungen in Richtung Anode orientiert, während sich die positiv geladenen Teile der ionischen Verbindungen in Richtung Kathode orientieren. Mittels dieser Ionenwanderung bildet sich also im Betrieb des Bauteils eine so genannte p-i-n-Struktur aus, wie sie beispielsweise in der OLED durch eine Multilagenabscheidung realisiert werden muss. Dabei steht p für p-leitend, i für intrinsisch und n für n-leitend. Für die Ausbildung dieser p-i-n-Struktur sind vorwiegend die Ionen des so genannten Matrixmaterials zuständig. Als Matrixmaterial werden bevorzugt ionische Flüssigkeiten eingesetzt. Dabei tragen diese Ionen weniger zum direkten Ladungstransport bei, als vielmehr zum Aufbau des internen elektrischen Feldes im Betrieb.

Neben dem Matrixmaterial befindet sich noch eine zweite ionische Komponente in der aktiven Schicht. Diese wird meist als Emitter bezeichnet, erfüllt aber neben der Aufgabe der Emission von Licht gleichermaßen die Aufgabe der Ladungstransportkomponente. Dafür liegt der so genannte Emitter in sehr hoher Konzentration, meist deutlich über 50 % in der aktiven Schicht vor. Die Bewältigung dieser beiden Aufgaben, der Lichtemission und des Stromtransportes, stellen eine große Beanspruchung des Emittermaterials dar. Dieses wird im Betrieb sehr stark belastet, was seine Lebensdauer deutlich herabsetzt. Außerdem kommt es insbesondere bei hohen Leuchtdichten zur Triplett-Triplett-Annihilation, welche die Effizienz des Emitters stark herabsetzt. Ein Grund für die Triplett-Triplett-Annihilation ist aus den Erkenntnissen im OLED-Bereich abzuleiten und auf die hohe Emitterkonzentration zurückzuführen. Diese kann jedoch nach dem vorliegenden Konzept nicht beliebig reduziert werden.

Daher ist es eine Aufgabe der Erfindung, bessere Emittermaterialien für OLEECs anzugeben.

Die Aufgabe ist durch eine Vorrichtung gemäß dem Patentanspruch 1 gelöst. Ein zugehöriges Herstellungsverfahren wird in Patentanspruch 10 angegeben. Vorteilhafte Ausgestaltungen der Erfindung sind Gegenstand der Unteransprüche.

Die erfindungsgemäße Vorrichtung ist ein lichtemittierendes Bauelement. Dieses weist wenigstens ein Substrat, eine erste und eine zweite Elektrode sowie eine aktive Schicht auf. Dabei weist die aktive Schicht zumindest einen ionischen Emitterkomplex auf. Der ionische Emitterkomplex ist aus einer neuen Emitterklasse gewählt, die sich dadurch auszeichnet, dass die im Komplex ligandzentrierte Emission stattfindet, d.h. dass der Übergang vornehmlich auf dem Liganden stattfindet. Gebräuchlich ist die englische Bezeichnung LC (ligand centered) für Emitterkomplexe, zu deren Emission vornehmlich die Liganden beitragen, im einfachen Bild entsteht die Emission also durch π-π*- oder n-π*-Übergänge. Im Gegensatz dazu stehen Intermetallübergänge in phosphoreszenten Emittern. Dieser sogenannte MLCT (metal to ligand charge transfer) trägt in der beschriebenen neuen Emitterklasse nur unwesentlich zur Emission bei.

Insbesondere ist also der ionische Emitterkomplex so ausgestaltet ist, dass der Anteil der ligandzentrierten Emission größer ist als der Anteil der auf Intermetallübergängen basierten Emission. Vorzugsweise beträgt der Anteil der ligandzentrierten Emission mehr als 70%, insbesondere mehr als 90%.

In einer vorteilhaften Ausgestaltung der Erfindung weist der ionische Emitterkomplex zumindest ein zentrales Kation und zumindest einen daran koordinierten Liganden umfasst. Dieser Ligand stammt aus der Klasse der niedermolekularen Halbleiter, den sogenannten kleinen Molekülen, die meist mit dem englischen Begriff "small molecules" bezeichnet werden. Das lichtemittierende Bauelement weist also eine neue Emitterklasse auf, die sich insbesondere durch die Koordinierung kleiner Moleküle an ein zentrales Kation auszeichnet. Das kleine Molekül ist neutral, so dass der ionische Emitterkomplex positiv geladen ist. Der ionische Emitterkomplex ist so ausgestaltet, dass der Anteil der ligandzentrierten Emission größer ist als der Anteil der auf Intermetallübergängen basierten Emission.

Als Elektronentransporter werden insbesondere heterozyklische stickstoffhaltige Aromaten eingesetzt:

| | | |
|---|---|---|
| 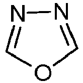 | 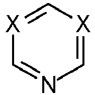 | X = C-H oder X = N |

Als Koordinationsstellen sind die Heteroatome O, S, Se, N, oder P geeignet. Diese Heteroatome können zur Koordination an ein positives Zentralion, insbesondere ein Metallkation genutzt werden. Dabei bilden sich insbesondere sehr stabile Komplexe, die auch rein isoliert werden können. Prinzipiell können als positives Zentralion alle Metallkationen des Periodensystems genutzt werden, besonders bevorzugt sind aber die Hauptgruppenelemente der Alkali- und Erdalkaligruppen, insbesondere das sehr kleine Lithium. Als positives Zentralion geeignet sind auch Ionen, wie Ammonium oder dessen substituierte Derivate.

In einem Beispiel für eine besonders vorteilhafte Ausgestaltung der Erfindung weist der Emitterkomplex ein zentrales Lithium-Kation auf und daran Phenanthrolinliganden koordiniert. In alternativen Formen dieser Verbindungen tritt Lithium 5-fach koordiniert auf. Normalerweise koordiniert Lithium zwei zweizähnige Liganden. Beispielsweise kann in einem Komplex, in dem die Koordinationsstelle 5 zunächst durch ein Lösungsmittel S, wie etwa THF besetzt ist, diese durch beispielsweise ein Lochleitermolekül besetzt werden. Damit können durch ein einziges Metallatom, oder allgemein zentrales Kation, sowohl elektronenleitende als auch lochleitende Moleküleinheiten in einem Komplex zusammengefasst werden:

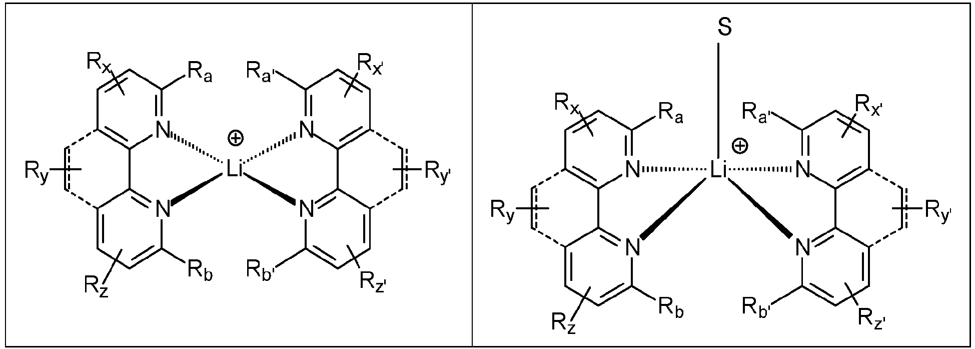

Als Lösungsmittel S sind besonders bevorzugt koordinierende Lösungsmittel wie THF, Pyridin oder Triarylamine, wie sie etwa auch als Lochleiter Verwendung finden.

Ob 4fach- oder 5fach-Koordination auftritt hängt vornehmlich vom Substituentenmuster Rₐ, R_{b}, am Phenanthrolinliganden ab. Die Substituenten Rₐ, R_{b}, Rₓ, R_{y}, R_{z} können auch mehrfach am Molekülgerüst auftreten. Die Substituenten Rₐ, R_{b}, Rₓ, R_{y}, R_{z} können insbesondere unabhängig voneinander sein:
- Methylreste,
- Ethylreste, oder verallgemeinert
- unverzweigte oder verzweigte,
- kondensierte (Decahydronaphthyl-) oder ringförmige (Cyclohexyl-) oder
- ganz oder teilweise substituierte Alkylreste (C₁ - C₂₀).

Diese Alkylreste können insbesondere enthalten:
- Ethergruppen (Ethoxy-, Methoxy-, usw.),
- Ester,
- Amid- oder Carbonatgruppen etc. oder auch
- Halogene, insbesondere F.

Geeignet sind auch substituierte oder unsubstituierte aliphatische Ringe bzw. Ringsysteme, wie etwa Cyclohexyl.

Rₐ, R_{b}, Rₓ, R_{y}, R_{z} sind nicht auf gesättigte Systeme beschränkt, sondern beinhalten insbesondere auch substituierte bzw. unsubstituierte Aromaten wie:
- Phenyl,
- Diphenyl,
- Naphthyl,
- Phenanthryl bzw.
- Benzyl etc.

Im Folgenden ist noch eine beispielhafte Zusammenstellung der als Substituenten in Frage kommenden Heterocyclen dargestellt:

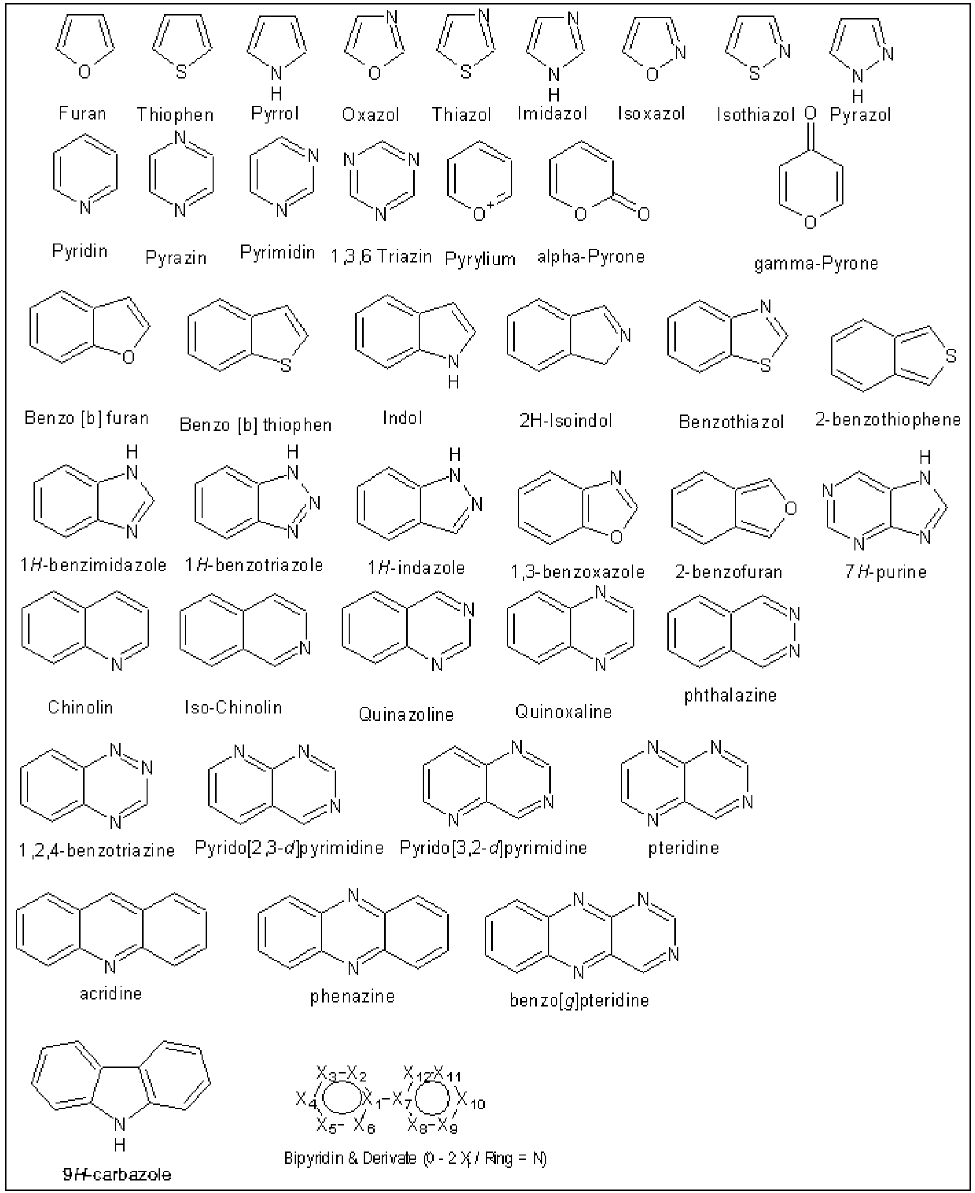

Für eine übersichtlichere Darstellung ist nur der Grundkörper der Aromaten dargestellt, jedoch kann prinzipiell jeder der Grundkörper mit weiteren Resten R substituiert sein, die sich analog von den hier definierten Reste R₁ₐ, R_{1b}, R₂ₐ und R_{2b} ableiten lassen. Die Bindung an den Liganden kann insbesondere an jeder bindungsfähigen Stelle des Grundkörpers erfolgen.

Insbesondere weist das lichtemittierende Bauelement eine aktive Schicht auf, welche ein Matrixmaterial aufweist, in das der ionische Emitterkomplex eingebracht ist. Insbesondere umfasst dieses Matrixmaterial eine ionische Flüssigkeit. Das lichtemittierende Bauelement funktioniert insbesondere als eine organische lichtemittierende elektrochemische Zelle. Dabei ist die ionische Matrix ein wesentlicher Bestandteil der aktiven Schicht für die Ausbildung einer p-i-n-Struktur im Betrieb des Bauteils. Im elektrischen Feld werden die Anionen in Richtung Anode orientiert und die Kationen in Richtung Kathode. Der eigentliche Ladungstransport erfolgt jedoch über den Emitterkomplex, der in das Matrixmaterial eingebracht ist.

Damit die OLEEC eine kurze Einschaltzeit besitzt, wird als Matrix eine ionische Komponente, insbesondere ein Salz zugesetzt. Vorzugsweise besitzt diese bei Raumtemperatur eine geringe Viskosität. Materialien dieser Art werden als ionische Flüssigkeit bezeichnet. Typische Vertreter sind beispielhaft, aber nicht einschränkend folgende:
- 1-Benzyl-3-methylimidazolium hexafluorophosphate
- 1-Butyl-2,3-dimethylimidazolium hexafluorophosphate
- 1-Butyl-3-methylimidazolium hexafluorophosphate
- 1-Ethyl-3-methylimidazolium hexafluorophosphate
- 1-Hexyl-3-methylimidazolium hexafluorophosphate
- 1-Butyl-1-(3,3,4,4,5,5,6,6,7,7,8,8,8-tridecafluorooctyl)imidazolium hexafluorophosphate
- 1-Methyl-3-(3,3,4,4,5,5,6,6,7,7,8,8,8-tridecafluorooctyl)imidazolium hexafluorophosphate
- 1-Methyl-3-octylimidazolium hexafluorophosphate
- 1-Butyl-2,3-dimethylimidazolium tetrafluoroborate
- 1-Butyl-3-methylimidazolium tetrafluoroborate
- 1-Ethyl-3-methylimidazolium tetrafluoroborate
- 1-Hexyl-3-methylimidazolium tetrafluoroborate
- 1-Methyl-3-octylimidazolium tetrafluoroborate
- 1-Butyl-3-methylimidazolium trifluoromethanesulfonate
- 1-Ethyl-3-methylimidazolium trifluoromethanesulfonate
- 1,2,3-Trimethylimidazolium trifluoromethanesulfonate
- 1-Ethyl-3-methyl-imidazolium bis(pentafluoroethylsulfonyl)imide
- 1-Butyl-3-methylimidazolium bis(trifluoromethylsulfonyl)imide
- 1-Butyl-3-methylimidazolium methanesulfonate
- Tetrabutylammonium bis-trifluoromethanesulfonimidate
- Tetrabutylammonium methanesulfonate
- Tetrabutylammonium nonafluorobutanesulfonate
- Tetrabutylammonium heptadecafluorooctanesulfonate
- Tetrahexylammonium tetrafluoroborate
- Tetrabutylammonium trifluoromethanesulfonate
- Tetrabutylammonium benzoate
- Tetrabutylammonium chloride
- Tetrabutylammonium bromide
- 1-Benzyl-3-methylimidazolium tetrafluoroborate
- Trihexyltetradecylphosphonium hexafluorophosphate
- Tetrabutylphosphonium methanesulfonate
- Tetrabutylphosphonium tetrafluoroborate
- Tetrabutylphosphonium bromide
- 1-Butyl-3-methylpyridinium bis(trifluormethylsulfonyl)imide
- 1-Butyl-4-methylpyridinium hexafluorophosphate
- 1-Butyl-4-methylpyridinium tetrafluoroborate Sodium tetraphenylborate
- Tetrabutylammonium tetraphenylborate
- Sodium tetrakis(1-imidazolyl)borate
- Cesium tetraphenylborate

Als Matrixmaterialien können insbesondere auch die folgenden Guanidiumverbindungen eingesetzt werden. Diese enthalten als zentrale Einheit mindestens eine Guanidiumeinheit mit positiver Ladung wie unten gezeigt. Die positive Ladung ist dabei naturgemäß mindestens innerhalb der Guanidiniumeinheit delokalisiert:

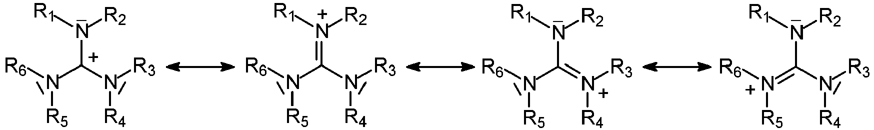

Dabei sind insbesondere alle Reste Rₙ (n = 1, 2, 3, 4, 5, 6), unabhängig voneinander: Rₙ = H, gesättigte oder ungesättigte verzweigte Alkylreste, unverzweigte Alkylreste, kondensierte Alkylreste, ringförmige Alkylreste, vollständig oder teilweise substituierte unverzweigte, verzweigte, kondensierte und/oder ringförmige Alkylreste, Alkoxygruppen, Amine, Amide, Ester, Carbonate, Aromaten, vollständig oder teilweise substituierte Aromaten, Heteroaromaten, kondensierte Aromaten, vollständig oder teilweise substituierte kondensierte Aromaten, Heterocyclen, vollständig oder teilweise substituierte Heterocyclen, kondensierte Heterocyclen, Halogene oder Pseudohalogene.

Alle Substituenten R₁, R₂, R+ können unabhängig von einander ausgewählt sein aus den oben genannten Resten, es handelt sich insbesondere um kondensierte z.B. decahydronaphtyl-, adamantyl-, cyclischer, cyclohexyl-, oder voll oder teilweise substituierte Alkylreste, bevorzugt C₁ bis C₂₀. Diese Ketten oder Gruppen können verschiedene Endgruppen tragen, beispielsweise geladene Endgruppen wie SOₓ⁻' NR⁺ oder andere.

Die Alkylreste können wiederum Gruppen wie Ether, Ethoxy-, Methoxy-, etc., Ester-, Amid-, Carbonat-, etc. oder Halogene, bevorzugt Fluor, tragen. R₁, R₂ und R₃ sollen aber nicht auf Alkylreste beschränkt sein, sondern können ebenso gut substituierte oder unsubstituierte aromatische Systeme umfassen, wie beispielsweise Phenyl-, Biphenyl-, Naphtyl-, Phenanthryl-, Benzyl- oder andere.

Die Substituenten R₁ bis R₆ können unabhängig voneinander aliphatisch, aromatisch oder komplex aufgebaut sein.

Durch Variation der der Reste R₁ bis R₆ lassen sich verschiedenartige Ligandsysteme erzeugen. Insbesondere können die Guanidium-Matrixmaterialien Liganden aus der Auswahl aller in dieser Anmeldung genannten Ligandensysteme umfassen.

In einer vorteilhaften Ausgestaltung der Erfindung wird das niedermolekulare Halbleitermaterial aus der Klasse der Ladungstransportmaterialien oder Emittermaterialien gewählt, welche insbesondere typischerweise Anwendung in organischen Leuchtdioden finden. Dies hat den Vorteil, dass somit der Emitterkomplex ein Transportmaterial umfasst, welches zu einem stark verbesserten Ladungstransport im Bauteil beiträgt. Es wird also eine neue OLEEC-Emitterklasse aus modifizierten OLED-Materialien angegeben.

Typische Lochtransportmaterialien, die zu einer Koordination an ein positiv geladenes Zentrum befähigt sind, sind beispielhaft, aber nicht einschränkend folgende:
- N, N'-Bis(naphthalen-1-yl)-N,N'-bis(phenyl)-9,9-dimethyl-fluorene
- N, N'-Bis(3-methylphenyl)-N,N'-bis(phenyl)-9,9-diphenyl-fluorene
- N, N'-Bis(naphthalen-1-yl)-N,N'-bis(phenyl)-9,9-diphenyl-fluorene
- N, N'-Bis(naphthalen-1-yl)-N,N'-bis(phenyl)-2,2-dimethylbenzidine
- N, N'-Bis(3-methylphenyl)-N,N'-bis(phenyl)-9,9-spirobifluorene
- 2,2',7,7'-Tetrakis(N, N-diphenylamino)-9,9'-spirobifluorene
- N, N'-Bis(naphthalen-1-yl)-N,N'-bis(phenyl)-benzidine
- N, N'-Bis(naphthalen-2-yl)-N,N'-bis(phenyl)-benzidine
- N, N'-Bis(3-methylphenyl)-N,N'-bis(phenyl)-benzidine
- N, N'-Bis(3-methylphenyl)-N,N'-bis(phenyl)-9,9-dimethyl-fluorene
- N, N'-Bis(naphthalen-1-yl)-N,N'-bis(phenyl)-9,9-spirobifluorene
- Di-[4-(N,N-ditolyl-amino)-phenyl]cyclohexane
- 2,2',7,7'-tetra(N, N-di-tolyl)amino-spiro-bifluorene
- 9,9-Bis[4-(N,N-bis-biphenyl-4-yl-amino)phenyl]-9H-fluorene
- 2,2',7,7'-Tetrakis[N-naphthalenyl(phenyl)-amino]-9,9-spirobifluorene
- 2,7-Bis[N,N-bis(9,9-spiro-bifluorene-2-yl)-amino]-9,9-spirobifluorene
- 2,2'-Bis[N,N-bis(biphenyl-4-yl)amino]-9,9-spirobifluorene
- N, N'-bis(phenanthren-9-yl)-N,N'-bis(phenyl)-benzidine
- N, N,N',N'-tetra-naphthalen-2-yl-benzidine
- 2,2'-Bis(N,N-di-phenyl-amino)-9,9-spirobifluorene
- 9,9-Bis[4-(N,N-bis-naphthalen-2-yl-amino)phenyl]-9H-fluorene
- 9,9-Bis[4-(N, N'-bis-naphthalen-2-yl-N,N'-bis-phenyl-amino)-phenyl]-9H-fluorene
- Titanium oxide phthalocyanine
- Copper phthalocyanine
- 2,3,5,6-Tetrafluoro-7,7,8,8,-tetracyano-quinodimethane
- 4,4',4" -Tris(N-3-methylphenyl-N-phenyl-amino)triphenylamine
- 4,4',4" -Tris(N-(2-naphthyl)-N-phenyl-amino)triphenylamine
- 4,4',4" -Tris(N-(1-naphthyl)-N-phenyl-amino)triphenylamine
- 4,4',4" -Tris(N,N-diphenyl-amino)triphenylamine
- Pyrazino[2,3-f][1,10]phenanthroline-2,3-dicarbonitrile
- N, N,N' ,N' -Tetrakis(4-methoxyphenyl)benzidine

Typische Elektronentransportmaterialien, die zu einer Koordination an ein positiv geladenes Zentrum befähigt sind, sind beispielhaft, aber nicht einschränkend folgende:
- 2,2',2" -(1,3,5-Benzinetriyl)-tris(1-phenyl-1-H-benzimidazole)
- 2-(4-Biphenylyl)-5-(4-tert-butylphenyl)-1,3,4-oxadiazole
- 2,9-Dimethyl-4,7-diphenyl-1,10-phenanthroline
- 8-Hydroxyquinolinolato-lithium
- 4-(Naphthalen-1-yl)-3,5-diphenyl-4H-1,2,4-triazole
- 1,3-Bis[2-(2,2'-bipyridine-6-yl)-1,3,4-oxadiazo-5-yl]benzene
- 4,7-Diphenyl-1,10-phenanthroline
- 3-(4-Biphenylyl)-4-phenyl-5-tert-butylphenyl-1,2,4-triazole
- Bis(2-methyl-8-quinolinolate)-4-(phenylphenolato)aluminium
- 6,6'-Bis[5-(biphenyl-4-yl)-1,3,4-oxadiazo-2-yl]-2,2'-bipyridyl
- 2-phenyl-9,10-di(naphthalen-2-yl)-anthracene
- 2,7-Bis[2-(2,2'-bipyridine-6-yl)-1,3,4-oxadiazo-5-yl]-9,9-dimethylfluorene
- 1,3-Bis[2-(4-tert-butylphenyl)-1,3,4-oxadiazo-5-yl]benzene
- 2-(naphthalen-2-yl)-4,7-diphenyl-1,10-phenanthroline
- 2,9-Bis(naphthalen-2-yl)-4,7-diphenyl-1,10-phenanthroline
- Tris(2,4,6-trimethyl-3-(pyridin-3-yl)phenyl)borane
- 1-methyl-2-(4-(naphthalen-2-yl)phenyl)-1H-imidazo[4,5-f][1,10]phenanthroline
- 4,7-di(9H-carbazol-9-yl)-1,10-phenanthroline
- 4-(Naphthalen-1-yl)-3,5-diphenyl-4H-1,2,4-triazole
- 4,4'-bis(4,6-diphenyl-1,3,5-triazin-2-yl)biphenyl
- 1,3-bis[3,5-di(pyridin-3-yl)phenyl]benzene
- 1,3,5-tri[(3-pyridyl)-phen-3-yl]benzene
- 3,3',5,5'-tetra[(m-pyridyl)-phen-3-yl]biphenyl

Beispiele, nicht einschränkend, für koordinierbare kleine Emittermoleküle sind:
- 3-(2-Benzothiazolyl)-7-(diethylamino)coumarin
- 2,3,6,7-Tetrahydro-1,1,7,7,-tetramethyl-1H, 5H,11H-10-(2-benzothiazolyl)
- N,N'-Dimethyl-quinacridone
- 9,10-Bis[N,N-di-(p-tolyl)-amino]anthracene
- 9,10-Bis[phenyl(m-tolyl)-amino]anthracene
- Bis[2-(2hydroxyphenyl)benzothiazolato]zinc(II)
- N¹⁰,N¹⁰,N¹⁰',N¹⁰'-tetra-tolyl-9,9'-bianthracene-10,10'-diamine
- N¹⁰,N¹⁰,N¹⁰',N¹⁰'-tetraphenyl-9,9'-bianthracene-10,10'-diamine
- N¹⁰,N¹⁰'-diphenyl-N¹⁰,N¹⁰'-dinaphthalenyl-9,9'-bianthracene-10,10'-diamine
- 4,4'-Bis(9-ethyl-3-carbazovinylene)-1,1'-biphenyl
- 1,4-Bis[2-(3-N-ethylcarbazoryl)vinyl]benzene
- 4,4' -Bis[4-(di-p-tolylamino)styryl]biphenyl
- 4-(Di-p-tolylamino)-4'-[(di-p-tolylamino)styryl]stilbene
- 4,4'-Bis[4-(diphenylamino)styryl]biphenyl
- Bis(2,4-difluorophenylpyridinato)tetrakis(1-pyrazolyl)borate iridium III
- N, N'-Bis(naphthalen-2-yl)-N,N'-bis(phenyl)-tris-(9,9dimethylfluorenylene)
- 2,7-Bis{2-[phenyl(m-tolyl)amino]-9,9-dimethyl-fluorene-7-yl}-9,9-dimethyl-fluorene
- N-(4-((E)-2-(6-((E)-4-(diphenylamino)styryl)naphthalen-2-yl)vinyl)phenyl)-N-phenylbenzenamine
- 1-4-di-[4-(N,N-di-phenyl)amino]styryl-benzene
- 1,4-bis(4-(9H-carbazol-9-yl)styryl)benzene
- (E)-6-(4-(diphenylamino)styryl)-N,N-diphenylnaphthalen-2-amine
- (E)-2-(2-(4-(dimethylamino)styryl)-6-methyl-4H-pyran-4-ylidene)malononitrile
- (E)-2-(2-tert-butyl-6-(2-(2,6,6-trimethyl-2,4,5,6-tetrahydro-1H-pyrrolo[3,2,1-ij]quinolin-8-yl)vinyl)-4H-pyran-4-ylidene)malononitrile
- 2,6-bis(4-(dip-tolylamino)styryl)naphthalene-1,5-dicarbonitrile
- 4-(Dicyanomethylene)-2-tert-butyl-6-(1,1,7,7-tetramethyljulolidin-4-yl-vinyl)-4H-pyran
- 4-(Dicyanomethylene)-2-methyl-6-(1,1,7,7-tetramethyljulolidyl-9-enyl)-4H-pyran
- 4-(Dicyanomethylene)-2-methyl-6-julolidyl-9-enyl-4H-pyran

Während die Koordination der niedermolekularen Halbleiter an das zentrale Kation die Leitfähigkeit nicht negativ beeinflusst, hat der Komplexierungsvorgang einen weiteren Vorteil, nämlich bezüglich der Emittereigenschaften der niedermolekularen Halbleiter. Deren Fluoreszenz, die besonders bei den Transportmaterialien nur sehr schwach ist, wird durch die Koordination derart verstärkt, dass der so gebildete Komplex als Emitter eingesetzt werden kann. Durch die Koordination wird also der HOMO-LUMO-Abstand, die Energielücke zwischen besetzten und unbesetzten Energieniveaus in den Molekülen also nur schwach beeinflusst, so dass die Leitfähigkeit nicht beeinträchtigt ist, das Übergansmoment wird jedoch so verändert, dass die Fluoreszenzintensität stark ansteigt.

In der Erfindung ist das zentrale Kation des Emitterkomplexes ein Alkalimetallkation oder Erdalkalimetallkation oder ein Ammoniumkation oder eines dessen substituierten Derivate. Insbesondere weist das in dem ionischen Emitterkomplex koordinierte niedermolekulare Halbleitermaterial betragsmäßig dieselbe Energielücke auf, wie das nicht koordinierte, neutrale niedermolekulare Halbleitermaterial. Dies hat den Vorteil, dass durch die Koordination, d.h. die Komplexierung, der Moleküle deren Leitfähigkeit bzw. deren Eigenschaft zum Ladungstransport in einer organischen Schicht erhalten bleibt.

Beispielsweise sind in dem ionischen Emitterkomplex mehrere neutrale Moleküle an das zentrale Kation koordiniert. D.h., der Emitterkomplex ist in seiner Ausdehnung deutlich größer als ein einzelnes neutrales kleines Molekül.

Es wird also durch die Komplexierung nicht nur eine Polarisierung des Moleküls erreicht, sondern auch eine "Ionisierung". Die Transportmaterialien an sich sind sehr unpolar und lösen sich daher schwer. Es wird eine neue Spezies gebildet, die ganz andere Lösungseigenschaften besitzt. Die Komplexe weisen eine verbesserte Löslichkeit auf und können somit im Gegensatz zu den neutralen kleinen Molekülen aus Lösung, wie beispielsweise einem Sol oder einer Etherlösung, verarbeitet werden.

In einer vorteilhaften Ausgestaltung der Erfindung weist das lichtemittierende Bauelement eine Strahlungsstärke von mindestens 5x10⁻⁵ Watt pro Steradiant und m² auf, in einem Wellenlängenbereich zwischen 400 und 500 nm. Insbesondere weist das lichtemittierende Bauelement ein Maximum der Strahlungsstärke in dem Wellenlängenbereich zwischen 420 und 460 nm auf, was einer tiefblauen Farbe entspricht. Dies ist von besonderem Vorteil, da noch mit keinem bisher bekannten Emitterkomplex für organische elektrochemische Zellen eine derartige Emissionsfarbe erreicht wurde.

Das erfindungsgemäße Herstellungsverfahren für ein lichtemittierendes Bauelement umfasst die folgenden Schritte: Zunächst die Synthese des ionischen Emitterkomplexes aus dem neutralen Molekül und einem Salz des zentralen Kations, dann das Einbringen dieses ionischen Emitterkomplexes in das Matrixmaterial und schließlich die Abscheidung der aktiven Schicht aus dem ionischen Emitterkomplex und dem Matrixmaterial auf der ersten Elektrode auf dem Substrat. Darauf wird schließlich noch die zweite Elektrode abgeschieden.

Dieses Verfahren hat den Vorteil, dass durch die Synthese des ionischen Emitterkomplexes aus neutralen kleinen Molekülen diese für die Verarbeitung aus Lösung tauglich gemacht werden können. Neben der Verarbeitbarkeit aus Lösung birgt die Komplexierung der neutralen kleinen Moleküle den weiteren Vorteil, dass deren ausgezeichnete Ladungstransporteigenschaften in das Bauelement eingebracht werden können. Darüber hinaus weisen die komplexierten Moleküle eine erhöhte Fluoreszenz auf.

Die verwendeten Salze weisen insbesondere einfache Anionen auf, die bevorzugt aber nicht einschränkend aus folgenden Beispielen ausgewählt werden:
- Fluorid,
- Sulfat,
- Phosphat,
- Carbonat,
- Trifluormethansulfonat,
- Trifluoracetat,
- Tosylat,
- Bis(trifluormethylsulfon)imid,
- Tetraphenylborat,
- B₉C₂H₁₁²,
- Hexafluorophosphat,
- Tetrafluoroborat,
- Hexafluoroantimonat,
- Tetrapyrazolatoborat.

Besonders bevorzugt sind:
- BF₄⁻,
- PF₆⁻,
- CF₃SO₃⁻,
- ClO₄⁻,
- SbF₆⁻.

Geeignet sind auch komplexe Anionen wie beispielsweise:
- Fe(CN)₆³⁻,
- Fe(CN)₆⁴⁻,
- Cr(C₂O₄)³⁻,
- Cu(CN)₄³⁻,
- Ni(CN)₄²⁻.

Experimentell hat sich gezeigt, dass die Halogene Chlorid, Bromid, Jodid hingegen als Quencher wirken.

Insbesondere erfolgt die Abscheidung der aktiven Schicht in einem nasschemischen Verfahren. Bevorzugt ist dabei das SpinCoating-Verfahren (Rotationsbeschichtung). Die Abscheidung der Schichten erfolgt generell bevorzugt aus Lösung, wie beispielsweise auch durch ein Druckverfahren, wie etwa Tintenstrahldruck, Tiefdruck oder Rakeln. Dabei sind als Lösungsmittel flüssige verdampfbare organische Substanzen geeignet, die im Folgenden beispielhaft, aber nicht einschränkend genannt sind:
- PGMEA = PropylenGlykolMonoEthyletherAcetat,
- Tetrahydrofuran,
- Dioxan,
- Chlorbenzol,
- Diethylenglykoldiethylether,
- Diethylenglykolmonoethylether,
- gamma-Butyrolacton,
- N-Methylpyrollidinon,
- Ethoxyethanol,
- Xylol,
- Toluol,
- Anisol,
- Phenetol,
- Acetonitril.

Auch weitere organische und anorganische sowie polare und unpolare Lösungsmittel sowie Lösungsmittelgemische sind einsetzbar.

Zusätzlich können noch polymere Verbindungen als Matrixmaterial mit in die Lösung eingebracht werden. Diese können etwa zur Verbesserung der halbleitenden Eigenschaften dienen. Auch kann die Beimischung eines Polymers zur Verbesserung der Filmbildungseigenschaften dienen, beispielsweise um eine gewisse erforderliche Mindestschichtdicke der aktiven Schicht zu realisieren. Beispielhaft aber nicht einschränkend können dies sein:
- Polyethyloxide (Polyethylenglykole),
- Polyethylendiamine,
- Polyacrylate wie Polymethylmethacrylat (PMMA) oder Polyacrylsäure bzw. deren Salze (Superabsorber),
- substituierte oder unsubstituierte Polystyrole wie Poly-p-hydroxy-styrol, Polyvinylalkohole, Polyester oder Polyurethane
- Polyvinylcarbazole,
- Poly-triaryamine,
- Polythiophene
- Polyvinylidenphenylene.

Die aktive Schicht wird also bevorzugt aus Lösung insbesondere auf ein Substrat mit geeigneter leitfähiger Elektrode aufgebracht. Die erste, untere Elektrode ist insbesondere eine Elektrode aus einem sogenannten TCO, einem transparenten leitfähigen Oxid, wie etwa Indiumzinnoxid (ITO), Aluminiumzinkoxid (AZO) oder dotierten Zinnoxiden. Dabei kann die Elektrode auch Hilfsschichten, etwa zur Planarisierung und/oder zur gleichmäßigen Stromverteilung aufweisen. Dazu eignen sich beispielsweise PEDOT:PSS (Poly(3,4-ethylene-dioxythiophene) poly(styrenesulfonate)) oder PANI (Polyanilin). Nach dem Trocknen der aktiven Schicht wird eine zweite, obere Elektrode als Deckelektrode aufgebracht. Da es sich um ein leuchtendes Bauelement handelt, ist zumindest eine der Elektroden transparent. Für die zweite Elektrode können insbesondere auch reflektierende Materialien wie Magnesium, Barium, Calcium und Aluminium bzw. dessen Legierungen, Edelmetalle wie Silber, Gold, Kupfer aber auch Nickel, Chrom etc. verwendet werden.

In einer vorteilhaften Ausgestaltung der Erfindung umfasst das Herstellungsverfahren folgende Syntheseschritte: Zunächst die Herstellung einer Lösung eines Salzes des zentralen Kations, dann die Herstellung einer Lösung des neutralen Moleküls und schließlich die Vereinigung der beiden Lösungen. Für die Herstellung der Lösung des neutralen kleinen Moleküls wird dabei insbesondere Dichlormethan verwendet, da diese Moleküle sehr schwer löslich sind. Nach der Komplexierung jedoch sind die Löslichkeitseigenschaften stark verbessert und es muss nicht mehr auf Dichlormethan zurückgegriffen werden. Zur Lösung des fertigen Emitterkomplexes sind auch Lösemittel wie beispielsweise Ether geeignet, die von Vorteil für die nasschemische Verarbeitung und Abscheidung einer organischen Halbleiterschicht sind.

In einer weiteren vorteilhaften Ausgestaltung der Erfindung umfasst die Synthese die Vereinigung der beiden Lösungen unter Schutzgasatmosphäre. Dabei werden nach dem Reaktionsschritt die Lösemittel abgezogen.

In einer weiteren vorteilhaften Ausgestaltung der Erfindung wird nach der Abscheidung der aktiven Schicht ein Temperaturschritt zur Trocknung vorgenommen. Insbesondere erfolgt nach der Abscheidung der zweiten Elektrode noch eine Verkapselung des gesamten Schichtsystems, das auf das Substrat aufgebracht wurde. Diese Verkapselung schützt insbesondere die organische aktive Halbleiterschicht vor schädlichem Sauerstoff- oder Wassereinfluss.

Ausführungsformen der vorliegenden Erfindung sind in exemplarischer Weise mit Bezug auf die Figuren 1 bis 6 beschrieben:
- Fig. 1: schematischer Aufbau einer OLEEC
- Fig. 2: Absorptionsspektrum der Komplexe 1a, 1b, 2a und 2b
- Fig. 3: Photolumineszenzspektrum der Komplexe 1a, 1b, 2a und 2b
- Fig. 4: Photolumineszenzspektrum des Komplex 1b und eines reinen Liganden
- Fig. 5: Elektrolumineszenzspektrum einer OLEEC
- Fig. 6: Lebensdauermessung, Strom in Abhängigkeit von der Zeit bei konstanter Spannung.

Im Folgenden werden vier Beispiele für Emitterkomplexe gegeben, deren Synthese beschrieben und Messdaten gezeigt. Dabei handelt es sich um kationisch blau emittierende Ammonium- und Alkalimetall-Komplexe mit zwei substituierten Phenanthrolinliganden: 4,7-Diphenyl-1,10-phenanthrolin und 2,9-Dimethyl-4,7 diphenyl-1,10 phenanthroline wurden als Liganden eingesetzt. Die verwendeten Lösungsmittel werden vor ihrer Verarbeitung insbesondere nach einer Standardprozedur getrocknet.

### Beispiele 1a und 1b:

### Synthese der Lithium basierten Metallkomplexe

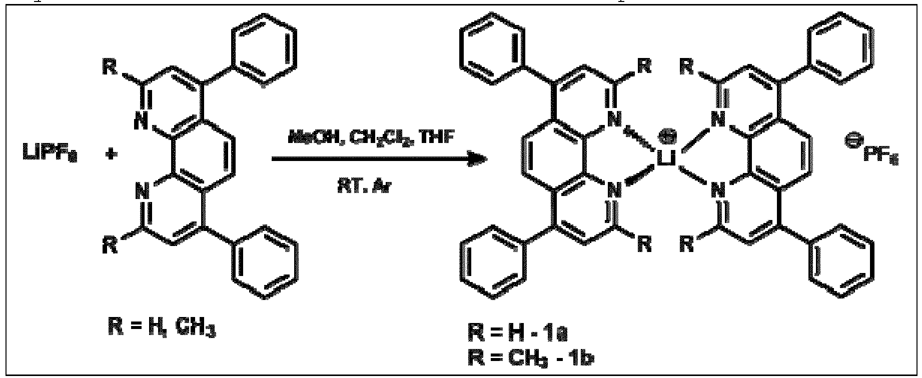

### 1a) Bis(4,7-Diphenyl-1,10-phenanthrolin)Lithium (I) Hexafluorophosphat:

1 Äquivalent LiPF₆ (Lithium Hexafluorophosphat)(0,073 mmol, 11,14 mg) wird in 2 ml Methanol gelöst und 2.05 Äquivalente 4,7-Diphenyl-1,10-phenanthrolin (0,15 mmol, 50 mg) (aufgereinigt durch Sublimation) werden in 5 ml Dichlormethan gelöst. Mit einer Kanüle werden beide Lösungen vereint und mit weiteren 10 ml frisch destilliertem sauerstofffreien Tetrahydrofuran versetzt. Die Mischung reagiert 4 Stunden bei Raumtemperatur unter Argonatmosphäre ab. Nach dem Entfernen des Lösungsmittels unter reduziertem Druck, wird der verbleibende weiß-gelbliche Feststoff in 8 ml Dioxan gelöst. Der ungelöste Feststoff wird herausgefiltert. Die Dioxan-Lösung wird unter Vakuum getrocknet. Danach liegt das Produkt als milchig-weißes Pulver (0,056 mmol, 46 mg, 77 %) vor.

### 1b) Bis(2,9-Dimethyl-4,7-Diphenyl-1,10-phenanthrolin)Lithium (I) Hexafluorophosphat:

1 Äquivalent LiPF₆ (0.067 mmol, 10.29 mg) wird in 2 ml Methanol gelöst und 2.05 Äquivalente 2,9-Dimethyl-4,7-Diphenyl-1,10-phenanthroline (0.138 mmol, 50 mg) (aufgereinigt durch Sublimation) warden in 5 ml Dichlormethan gelöst. Mit einer Kanüle werden beide Lösungen vereint und mit weiteren 10 ml frisch destilliertem sauerstofffreien Tetrahydrofuran versetzt. Die Mischung reagiert 4 Stunden bei Raumtemperatur unter Argonatmosphäre ab. Nach dem Entfernen des Lösungsmittels unter reduziertem Druck, wird der verbleibende weiß-gelbliche Feststoff im 8 ml Dioxan gelöst. Der ungelöste Feststoff wird herausgefiltert und die Dioxan Lösung unter Vakuum getrocknet. Danach liegt das Produkt als milchig-weißes Pulver (0.044 mmol, 38 mg, 66 %) vor.

### Beispiele 2a und 2b:

### Synthese der Ammonium basierten Metallkomplexe

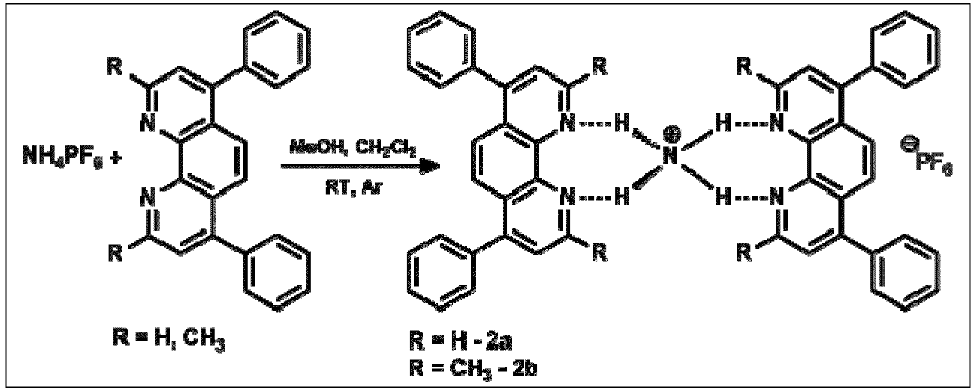

### 2a) Bis(4,7-Diphenyl-1,10-phenanthrolin)Ammonium Hexafluorophosphat:

1 Äquivalent Ammonium Hexafluorophosphat (NH₄PF₆) (0.075 mmol, 11,96 mg) wird in 2 ml Methanol gelöst und 2.05 Äquivalente des 4,7-Diphenyl-1,10-phenanthrolin Liganden (0.15 mmol, 50 mg) (aufgereinigt durch Sublimation) werden in 4 ml Dichlormethan gelöst. Die Mischung wird dann in einen 50 ml Schlenkrohr gegeben und reagiert dort über mehrere Stunden bei Raumtemperatur unter Argonatmosphäre ab. Das Lösungsmittel wird dann unter vermindertem Druck abgezogen und ein weißes Pulver bleibt als Produkt zurück. Das Produkt kann ohne weitere Reinigung für die spektroskopischen Untersuchungen verwendet werden.

### 2b) Bis(2,9-Dimethyl-4,7-Diphenyl-1,10-phenanthrolin)Ammonium Hexafluorophosphat:

1 Äquivalent NH₄PF₆ (0.075 mmol, 11,96 mg) wird in 2 ml Methanol gelöst und 2.05 Äquivalente des 4,7-Diphenyl-1,10-phenanthrolin Liganden (0.15 mmol, 50 mg) (aufgereinigt durch Sublimation) werden in 4 ml Dichlormethan gelöst. Die Mischung wird dann in einen 50 ml Schlenkrohr gegeben und reagiert dort über mehrere Stunden bei Raumtemperatur unter Argonatmosphäre ab. Das Lösungsmittel wird dann unter vermindertem Druck abgezogen und ein weißes Pulver bleibt als Produkt zurück. Das Produkt kann ohne weitere Reinigung für die spektroskopischen Untersuchungen verwendet werden.

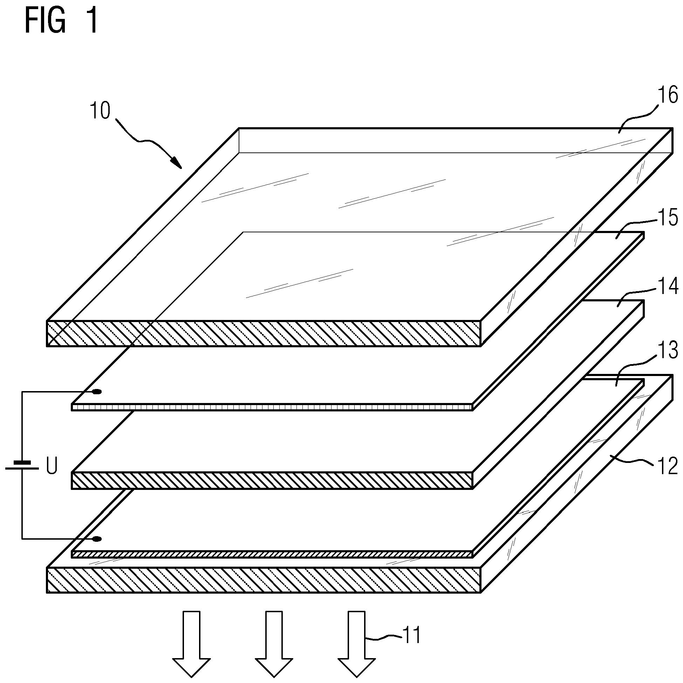

Die Figur 1 zeigt schematisch den Aufbau einer organischen lichtemittierenden elektrochemischen Zelle (OLEEC). In der Figur 1 sind die horizontal angeordneten Schichten perspektivisch gezeigt und für die Deutlichkeit der Darstellung nicht in direktem Kontakt zueinander gezeichnet. Die Schichten werden aber direkt aufeinander abgeschieden und stehen somit großflächig miteinander in Kontakt. Von unten her angefangen zeigt die Figur 1 zunächst das Substrat 12, welches insbesondere ein Glassubstrat, auf jedem Fall aber ein transparentes Substrat, ist, durch das das in der OLEEC erzeugte Licht 11 austreten kann. Auf diesem Substrat 12 befindet sich eine zumindest semitransparente Elektrode 13. Diese ist insbesondere eine Indium-Zinn-Oxid-Elektrode (ITO), welche z. B. durch Sputtern direkt auf das Glassubstrat aufgetragen ist. Die Strukturierung z. B. in mehrere Pixel erfolgt häufig über die Strukturierung dieser unteren Elektrode 13. Die untere Elektrode 13 kann aber auch aus mehreren Lagen bestehen. Beispielsweise ist die untere Elektrode aus einer ITO-Schicht und einer Polymerschicht aufgebaut. Beispielsweise wird als Polymer PEDOT:PSS (Poly(3,4-ethylenedioxythiophene) poly(styrenesulfonate)) verwendet. Die Polymerschicht dient etwa zur Nivellierung der ITO-Elektrode und/oder zur Unterstützung der Lochinjektion.

Im Betrieb wird eine Bauteilspannung U angelegt, so dass die untere Elektrode 13 als Anode fungiert. Auf die untere Elektrode 13 folgt die aktive Schicht 14 aus organischem Halbleitermaterial. In dieser aktiven Schicht 14 sind der Emitterkomplex und das Matrixmaterial vorhanden. Auf diese aktive Schicht 14 wird eine obere Elektrode 15 abgeschieden, die im Bauteil insbesondere als Kathode fungiert. Diese obere Elektrode 15 ist beispielsweise eine Metallelektrode und kann durch thermisches Verdampfen auf die aktive Schicht abgeschieden werden.

Auf diese obere Elektrode 15 kann nun noch eine Verkapselung 16 folgen, die in ihrer Ausdehnung jedoch größer als die darunterliegenden Elektroden 13, 15 und die aktive Schicht 14 ist und die zusammen mit dem Substrat 12 dieses Schichtsystem so einschließt, dass es vor Sauerstoff und Wasser geschützt ist.

Ein Beispiel für eine beschriebene OLEEC kann folgendermaßen aufgebaut sein: Die aktive Fläche des OLEEC Bauteils 10 beträgt beispielsweise 4 mm², welche durch die Fläche der ITO-Anode 13 vorgegeben ist. Die aktive Schicht 14 wird mittels Spincoat-Technik auf ITO-Glassubstraten 12, 13 abgeschieden.

Die Aluminium-Kathode 15 wird mittels thermischem Verdampfen hergestellt. Eine 100 nm PEDOT:PSS Schicht wird beispielsweise eingebaut, um die Oberfläche der ITO-Anode 13 zu nivellieren und den Lochtransport zu begünstigen. Die organische emittierende Schicht 14 wird dann also beispielsweise zwischen der PEDOT:PSS-Schicht und der Kathode 15 eingebaut. Die Schichtdicke der Aluminium-Kathode 15 beträgt zwischen 80 und 130 nm. Die Emissionsschicht 14 wird insbesondere folgendermaßen präpariert: 36 mg des Emitterkomplexes 1b wird zusammen mit dem Matrixmaterial, dem Ionenleiter ([BMIM]⁺ [PF₆]⁻) in 0.5 ml Anisol in einem Molverhältnis von 3:1 gelöst. Vor dem Spincoating wurde die Lösung mit einem 0.1 µm PTFE-Filter gefiltert. Der aufgetragene Film 14 wurde über 1 Stunde bei 100 °C getrocknet. Schließlich wurde die Kathode 15, bestehend aus 150 bis 200 nm Aluminium aufgedampft. Eine nachfolgende Verkapselung 16 schützt die organische Schicht 14 vor der Wechselwirkung mit Luftmolekülen und Wasser.

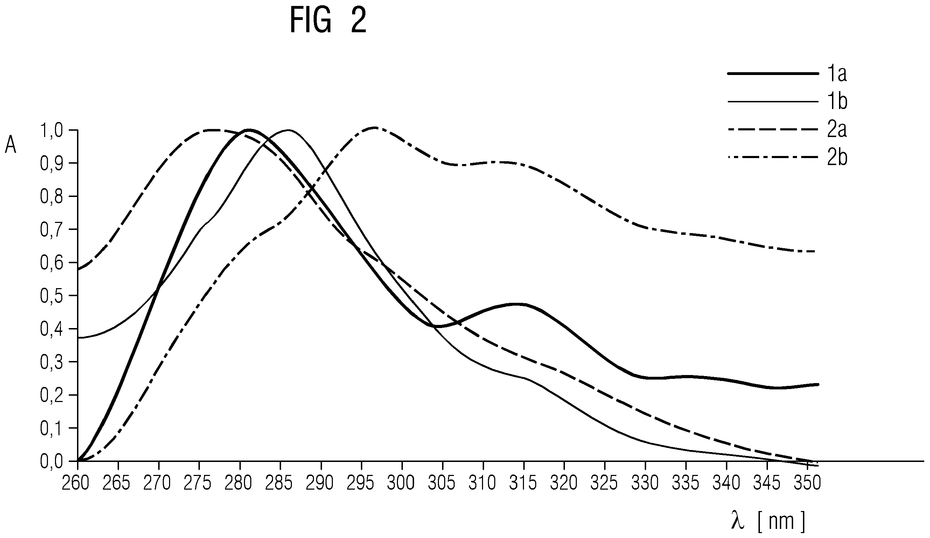

Figur 2 zeigt das Absorptionsspektrum der Komplexe 1a, 1b, 2a und 2b. Die Komplexe sind für die Messung der Absorption A in DCM (Dichlormethan) gelöst und wurden bei Raumtemperatur gemessen. Dabei ist in dem Diagramm die Absorption A in normierten Einheiten in Abhängigkeit von der Wellenlänge λ aufgetragen.

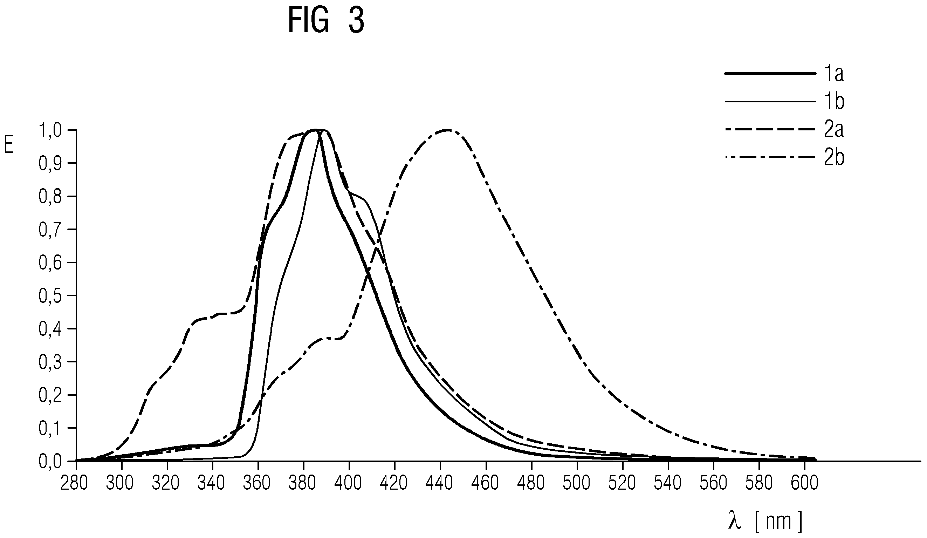

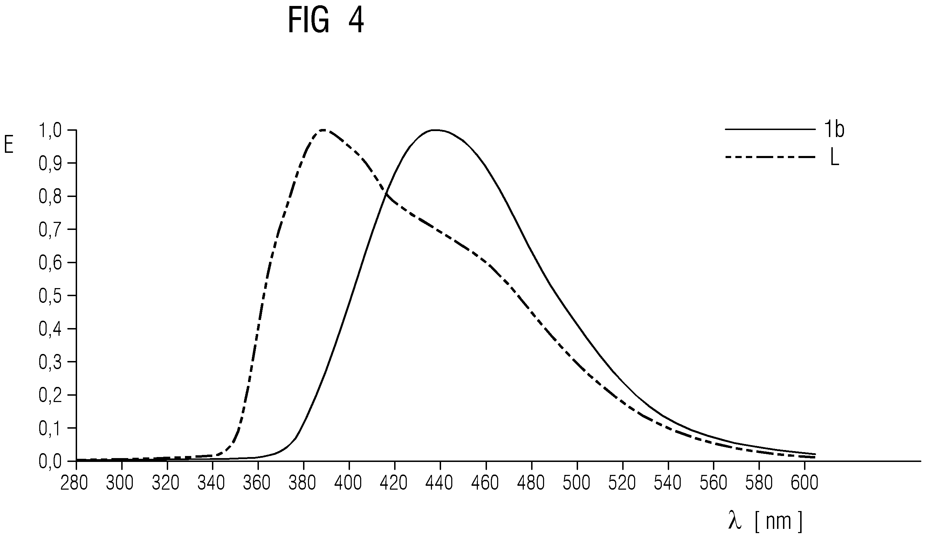

Die Figur 3 zeigt die dazugehörigen Photolumineszenzspektren der gleichen Proben, ebenfalls in einer DCM-Lösung vorliegend und bei Raumtemperatur gemessen. Alle gezeigten Komplexe 1a, 1b, 2a und 2b haben das Maximum deutlich unterhalb des grünen Wellenlängenbereichs. In Figur 4 sind wiederum Photolumineszenzspektren gezeigt, wobei in diesem Fall die Proben nicht in Lösung vorliegen, sondern abgeschiedene Schichten auf einem Glassubstrat vermessen wurden. In Figur 4 ist der Vergleich zwischen dem Photolumineszenzspektrum des Komplexes 1b mit dem Photolumineszenzspektrum des für den Komplex 1b verwendeten Liganden L gezeigt. Diese Darstellung macht deutlich, dass das nicht koordinierte Halbleitermaterial die maximale Emission E im nicht sichtbaren Bereich aufweist. Der mit diesem Liganden L gebildete Emitterkomplex 1b jedoch emittiert bei einer Wellenlänge von 440 nm.

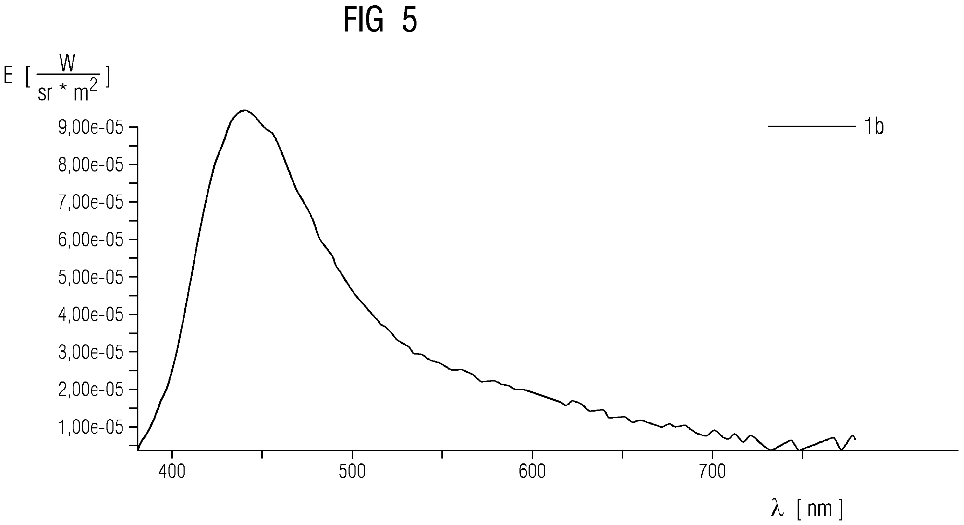

Die Figur 5 zeigt das Elektrolumineszenzspektrum einer OLEEC mit dem Emitterkomplex 1b in der aktiven Schicht. Genauso wie schon die Photolumineszenz der Emitterschicht zeigt auch das Bauteil im Betrieb ein Maximum der Emission bei 440 nm, welches gegenüber der Emission der anderen Farbbereiche so hoch ist, dass das Bauteil in einer tiefblauen Farbe leuchtet. Mit einer Spektralkamera (PR 650) wurde das Spektrum im Sichtbarenbereich zwischen 380 und 780 nm detektiert. Bei einer angelegten Spannung U von 11 V emittiert die OLEEC mit dem Emitterkomplex 1b mit einem lokalen Maximum bei 440 nm. Die Farb-Koordinaten dieses Bauteils im CIE-1931-Diagramm (CIE-Commission internationale d'éclairage) betragen: x=0,19 und y=0,18.

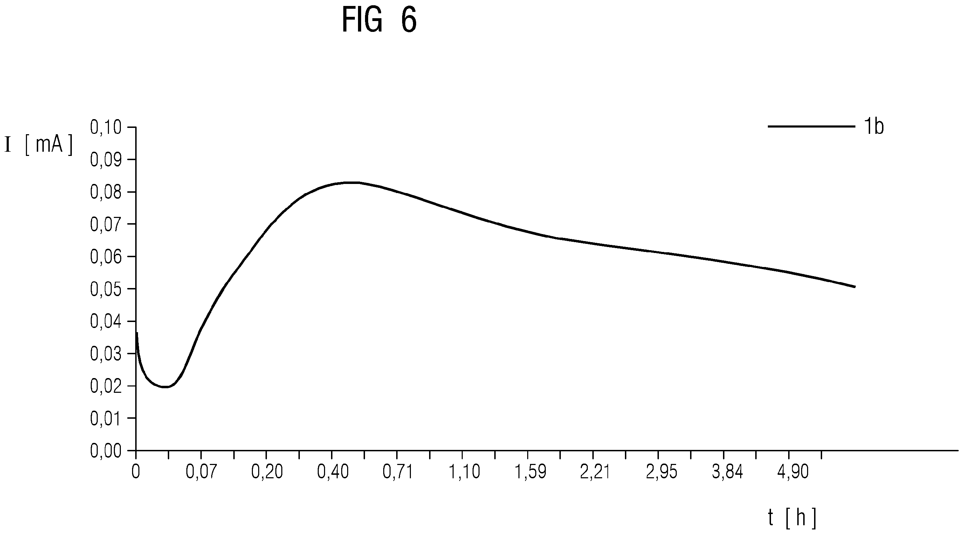

Figur 6 zeigt schließlich noch das Lebensdauerverhalten eines derartigen Bauteils. Dazu wurde bei einer konstanten Spannung der Strom I durch das Bauteil über die Zeit t gemessen.

Hier wurde die Spannung U konstant auf 11 V gesetzt und der Strom sekündlich abgetastet. Die Strom-Kennlinie zeigt ein typisches Verhalten einer OLEEC.

## Patentansprüche

1. Lichtemittierendes Bauelement (10) mit wenigstens einem Substrat (12), einer ersten Elektrode (13) und einer zweiten Elektrode (15) sowie einer aktiven Schicht (14), wobei die aktive Schicht (14) zumindest einen ionischen Emitterkomplex umfasst, **dadurch gekennzeichnet, dass** der ionische Emitterkomplex ausgestaltet ist, ligandzentriert zu emittieren,
- wobei das lichtemittierende Bauelement (10) eine organische elektrochemische Zelle ist,
- wobei der ionische Emitterkomplex zumindest ein zentrales Kation und zumindest einen daran koordinierten Liganden umfasst, wobei das zentrale Kation ein Alkali- oder Erdalkalimetallkation oder Ammonium oder dessen substituierte Derivate ist,
- wobei der zumindest eine Ligand ein kleines Molekül ist,
- wobei das kleine Molekül neutral ist, so dass der ionische Emitterkomplex positiv geladen ist,
- wobei der ionische Emitterkomplex so ausgestaltet ist, dass der Anteil der ligandzentrierten Emission größer als der Anteil der auf Intermetallübergängen basierten Emission ist.

2. Lichtemittierendes Bauelement (10) nach dem vorstehenden Anspruch, wobei die aktive Schicht (14) ein Matrixmaterial umfasst, in das der ionische Emitterkomplex eingebracht ist.

3. Lichtemittierendes Bauelement (10) nach Anspruch 2, wobei das Matrixmaterial eine ionische Flüssigkeit umfasst.

4. Lichtemittierendes Bauelement (10) nach einem der vorstehenden Ansprüche, wobei der Ligand ein Transportmaterial ist.

5. Lichtemittierendes Bauelement (10) nach einem der vorstehenden Ansprüche, wobei der Ligand ein Emittermaterial ist, insbesondere ein fluoreszentes Emittermaterial.

6. Lichtemittierendes Bauelement (10) nach einem der vorstehenden Ansprüche, wobei das in dem ionischen Emitterkomplex koordinierte kleine Molekül betragsmäßig im Wesentlichen die gleiche Energielücke aufweist wie das nicht koordinierte, neutrale kleine Molekül.

7. Lichtemittierendes Bauelement (10) nach einem der vorstehenden Ansprüche, wobei in dem ionischen Emitterkomplex mehrere neutrale kleine Moleküle an das zentrale Kation koordiniert sind.

8. Herstellungsverfahren für ein lichtemittierendes Bauelement durch die Schritte gekennzeichnet:
- Synthese eines ionischen Emitterkomplexes aus einem neutralen kleinen Molekül als Ligand und einem Salz eines zentralen Kations,
- wobei der ionische Emitterkomplex zumindest ein zentrales Kation und zumindest einen daran koordinierten Liganden umfasst, wobei das zentrale Kation ein Alkali- oder Erdalkalimetallkation oder Ammonium oder dessen substituierte Derivate ist,
- wobei der zumindest eine Ligand ein kleines Molekül ist,
- wobei das kleine Molekül neutral ist, so dass der resultierende ionische Emitterkomplex positiv geladen ist,
- wobei der ionische Emitterkomplex so ausgestaltet ist, dass der Anteil der ligandzentrierten Emission größer als der Anteil der auf Intermetallübergängen basierten Emission ist,
- Einbringen des ionischen Emitterkomplexes in ein Matrixmaterial,
- Abscheidung einer aktiven Schicht (14) auf einer ersten Elektrode (13) auf einem Substrat (11), wobei nach der Abscheidung der aktiven Schicht (14) ein Temperaturschritt zur Trocknung vorgenommen wird,
- Abscheidung einer zweiten Elektrode (15) auf der aktiven Schicht (14), so dass als lichtemittierendes Bauelement (10) eine organische elektrochemische Zelle erzeugt wird.

9. Herstellungsverfahren nach Anspruch 8, wobei die Abscheidung der aktiven Schicht (14) in einem nasschemischen Verfahren erfolgt.

10. Herstellungsverfahren nach einem der Ansprüche 8 oder 9, wobei die Synthese die Schritte umfasst:
- Herstellung einer Lösung eines Salzes des zentralen Kations,
- Herstellung einer Lösung des neutralen kleinen Moleküls,
- Vereinigung der beiden Lösungen, wobei die Vereinigung der beiden Lösungen unter Schutzgasatmosphäre erfolgt und
- nach dem Reaktionsschritt das Abziehen der Lösemittel erfolgt.

## Claims

1. Light-emitting component (10) having at least one substrate (12), a first electrode (13) and a second electrode (15), and also an active layer (14), wherein the active layer (14) comprises at least one ionic emitter complex, **characterized in that** the ionic emitter complex is configured for ligand-centered emission,
- wherein the light-emitting component (10) is an organic electrochemical cell,
- wherein the ionic emitter complex comprises at least one central cation and at least one ligand coordinated thereto wherein the central cation is an alkali metal or alkaline earth metal cation or ammonium or substituted derivatives thereof,
- wherein the at least one ligand is a small molecule,
- wherein the small molecule is uncharged, and so the ionic emitter complex is positively charged,
- wherein the ionic emitter complex is configured such that the proportion of ligand-centered emission is greater than the proportion of emission based on intermetallic transitions.

2. Light-emitting component (10) according to the preceding claim, wherein the active layer (14) comprises a matrix material in which the ionic emitter complex has been incorporated.

3. Light-emitting component (10) according to Claim 2, wherein the matrix material comprises an ionic liquid.

4. Light-emitting component (10) according to any of the preceding claims, wherein the ligand is a transport material.

5. Light-emitting component (10) according to any of the preceding claims, wherein the ligand is an emitter material, especially a fluorescent emitter material.

6. Light-emitting component (10) according to any of the preceding claims, wherein the small molecule coordinated within the ionic emitter complex has an energy gap of essentially the same order of magnitude as the uncoordinated, uncharged small molecule.

7. Light-emitting component (10) according to any of the preceding claims, wherein several uncharged small molecules are coordinated to the central cation in the ionic emitter complex.

8. Production process for a light-emitting component, **characterized by** the steps of:
- synthesis of an ionic emitter complex from an uncharged small molecule as a ligand and a salt of a central cation,
- wherein the ionic emitter complex comprises at least one central cation and at least one ligand coordinated thereto, wherein the central cation is an alkali metal or alkaline earth metal cation or ammonium or substituted derivatives thereof,
- wherein the at least one ligand is a small molecule,
- wherein the small molecule is uncharged, and so the resulting ionic emitter complex is positively charged,
- wherein the ionic emitter complex is configured such that the proportion of ligand-centered emission is greater than the proportion of emission based on intermetallic transitions,
- introduction of the ionic emitter complex into a matrix material,
- deposition of an active layer (14) on a first electrode (13) on a substrate (11), wherein the deposition of the active layer (14) is followed by a thermal step for drying,
- deposition of a second electrode (15) on the active layer (14) and so an organic electrochemical cell is produced as light-emitting component (10).

9. Production process according to Claim 8, wherein the active layer (14) is deposited in a wet-chemical process.

10. Production process according to either of Claims 8 and 9, wherein the synthesis comprises the steps of:
- preparing a solution of a salt of the central cation,
- preparing a solution of the uncharged small molecule,
- combining the two solutions, the two solutions being combined under protective gas atmosphere, and
- after the reaction step, drawing off the solvents.

## Revendications

1. Composant électroluminescent (10) comprenant au moins un substrat (12), une première électrode (13) et une deuxième électrode (15), ainsi qu'une couche active (14), la couche active (14) comprenant au moins un complexe émetteur ionique, **caractérisé en ce que** le complexe émetteur ionique est configuré pour émettre de manière centrée sur le ligand,
- le composant électroluminescent (10) étant une cellule électrochimique organique,
- le complexe émetteur ionique comprenant au moins un cation central et au moins un ligand coordonné à celui-ci, le cation central étant un cation de métal alcalin ou alcalino-terreux ou l'ammonium ou ses dérivés substitués,
- ledit au moins un ligand étant une petite molécule,
- la petite molécule étant neutre, de sorte que le complexe émetteur ionique soit chargé positivement,
- le complexe émetteur ionique étant configuré de sorte que la proportion de l'émission centrée sur le ligand soit supérieure à la proportion de l'émission fondée sur les transitions entre métaux.

2. Composant électroluminescent (10) selon la revendication précédente, dans lequel la couche active (14) comprend un matériau de matrice dans lequel le complexe émetteur ionique est introduit.

3. Composant électroluminescent (10) selon la revendication 2, dans lequel le matériau de matrice comprend un liquide ionique.

4. Composant électroluminescent (10) selon l'une quelconque des revendications précédentes, dans lequel le ligand est un matériau de transport.

5. Composant électroluminescent (10) selon l'une quelconque des revendications précédentes, dans lequel le ligand est un matériau émetteur, notamment un matériau émetteur fluorescent.

6. Composant électroluminescent (10) selon l'une quelconque des revendications précédentes, dans lequel la petite molécule coordonnée dans le complexe émetteur ionique présente en valeur essentiellement la même bande interdite que la petite molécule neutre non coordonnée.

7. Composant électroluminescent (10) selon l'une quelconque des revendications précédentes, dans lequel plusieurs petites molécules neutres sont coordonnées au cation central dans le complexe émetteur ionique.

8. Procédé de fabrication d'un composant électroluminescent, **caractérisé par** les étapes suivantes :
- la synthèse d'un complexe émetteur ionique à partir d'une petite molécule neutre en tant que ligand et d'un sel d'un cation central,
- le complexe émetteur ionique comprenant au moins un cation central et au moins un ligand coordonné à celui-ci, le cation central étant un cation de métal alcalin ou alcalino-terreux ou l'ammonium ou ses dérivés substitués,
- ledit au moins un ligand étant une petite molécule,
- la petite molécule étant neutre de sorte que le complexe émetteur ionique résultant soit chargé positivement,
- le complexe émetteur ionique étant configuré de sorte que la proportion de l'émission centrée sur le ligand soit supérieure à la proportion de l'émission fondée sur les transitions entre métaux,
- l'introduction du complexe émetteur ionique dans un matériau de matrice,
- le dépôt d'une couche active (14) sur une première électrode (13) sur un substrat (11), une étape de chauffage étant réalisée pour le séchage après le dépôt de la couche active (14),
- le dépôt d'une deuxième électrode (15) sur la couche active (14), de manière à former une cellule électrochimique organique en tant que composant électroluminescent (10).

9. Procédé de fabrication selon la revendication 8, dans lequel le dépôt de la couche active (14) a lieu par un procédé chimique humide.

10. Procédé de fabrication selon l'une quelconque des revendications 8 ou 9, dans lequel la synthèse comprend les étapes suivantes :
- la fabrication d'une solution d'un sel du cation central,
- la fabrication d'une solution de la petite molécule neutre,
- la réunion des deux solutions, la réunion des deux solutions ayant lieu dans une atmosphère de gaz protecteur, et
- après l'étape de réaction, l'extraction du solvant ayant lieu.
